# EUROPEAN PATENT SPECIFICATION

(11) **EP 0 870 326 B1**
(45) Date of publication and mention of the grant of the patent: **31.05.2000**
(21) Application number: 96934619.6
(22) Date of filing: 10.10.1996
(51) Int. Cl.: H01L 21/70, H01L 27/01

(54) **MANUFACTURING PROCESS FOR THIN-FILM CIRCUITS COMPRISING INTEGRATED CAPACITORS**
VERFAHREN ZUR HERSTELLUNG VON DÜNNFILMSCHALTUNGEN MIT INTEGRIERTEN KONDENSATOREN
PROCEDE POUR FABRIQUER DES CIRCUITS A FILM MINCE COMPRENANT DES CONDENSATEURS INTEGRES

(30) Priority: 29.11.1995 IT MI952486
(43) Date of publication of application: 14.10.1998
(73) Proprietor: Italtel s.p.a., 20154 Milano (IT)
(72) Inventor: CARCANO, Giorgio, I-20043 Arcore (IT); LAZZARI, Stefano, I-20099 Sesto S. Giovanni (IT); MAGLIOCCO, Massimo, I-20052 Monza (IT)
(74) Representative: Giustini, Delio
(86) International application number: EP9604406
(87) International publication number: WO9720345

(56) References cited:
- EP-A- 0 670 668
- US-A- 4 436 766
- IEEE TRANSACTIONS ON ELECTRON DEVICES, vol. ED-30, no. 1, January 1983, NEW YORK US, pages 21-26, XP000611740 A. CHU ET AL.: "A two-stage monolithic IF amplifier utilizing a Ta2O5 capacitor"

## Description

The present invention relates to the field of industrial processes for creating hybrid thin-film circuits on dielectric substrates for microwave applications and specifically to a manufacturing process for thin-film circuits comprising integrated capacitors.

As known, in the above mentioned technical field one of the problems posed by the requirement to achieve more complete circuit integration is creating in a single production process all the passive elements together with the conductive paths of the interconnections. Initially the processes of depositing thin films on dielectric substrates were predominantly aimed at creating resistors and inductors and conductive lines and excluded the capacitors, for which it was necessary to use chip components connected to the circuit by means of surface mounting techniques. Subsequently, the thrust for the search for a greater integration led to the development of processes of deposit of thin films extending to the capacitors.

The integration of small capacitors with characteristics readily repeatable in the production process results in undoubted advantages among which are reduction of production costs, achievement of a greater degree of circuit miniaturization, the faculty of better optimizing the layout, extension in frequency of the operating band of the associated circuits and reduction of parasite parameters.

In the article by G.P. Ferraris and R. May entitled "TANTALUM THIN FILM CAPACITORS WITH VARIOUS TYPES OF COUNTERELECTRODES", published in "Electrocomponent Science and Technology", Vol. 6, pages 235-240, year 1980, published by Gordon and Breach Science Publishers, Inc, Great Britain, are set forth the measurement results of the principal electrical parameters of thin-film capacitors whose dielectric consists of a layer of tantalum pentoxide (Ta₂O₅), created by subjecting to a known electrolytic process (anodizing) a layer of tantalum (Ta) used as the lower electrode in capacitors. The Ta₂O₅ possesses a relative dielectric constant around 25, which is much greater than that of the more common materials used for the same purpose and thus allows creating capacitors with high surface density of capacitance.

The above mentioned capacitors were developed by the same authors in the laboratories of the applicant, using a process which integrated on a single substrate the tantalum resistive paths, the capacitors and the gold conductive paths.

The article investigates the possibility of reducing the resistivity of the tantalum layer constituting the material of the lower electrode of the integrated capacitors, introducing a dopant nitrogen flow during the vacuum cathode tantalum sputtering.

The investigation continues by examining in addition the electrical characteristics of capacitors which differ only in the type of metal used in the sputtering phase of the material constituting the upper electrode.

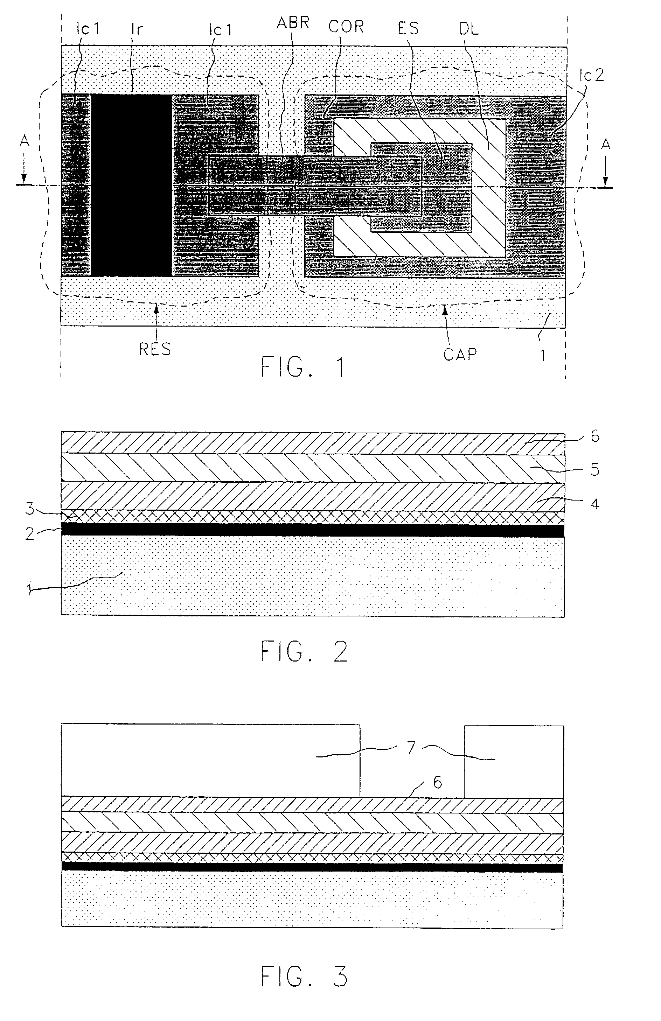

As concerns the first point, the results of the investigation are set forth in the quotation in Table 1 and FIG 1 on page 236, from which it appears that the doping with nitrogen effectively reduces the resistivity of the tantalum layer making up the lower electrode, while causing at the same time a change of sign and an increase in the positive value of the temperature coefficient (TCR) of the layer and simultaneous reduction of the capacitance density of the capacitor. On the contrary, the requirement for having a TCR as near zero as possible together with high capacitance densities prevents minimization of the resistivity of the tantalum in this type of capacitor, which is therefore always characterized by high values of equivalent series resistance (ESR).

Recalling that for a generic capacitor the value of the dissipation factor tan δ gives an idea of how much the electrical behaviour deviates from the ideal case, and that tan δ = tan δ' + ωCR_{o,} where Rₒ = ESR and the term tan δ' allows for an intrinsic loss of the independent dielectric by the frequency, it can be noted that only the presence of an ESR introduces a power dissipation which increases with the increase in frequency, ESR and capacitance.

From the foregoing it is clear that the great shortcoming of thin film circuits which integrate capacitors with Ta₂O₅ dielectric created by anodizing a tantalum layer previously deposited by photoengraving of the resistive paths, is to show a small value (< 10 kHz) in the upper limit of the operating frequencies. A partial remedy for this shortcoming consists of improving the conductivity of the lower electrode by means of a layer of aluminum underlying the tantalum layer as described for example in the article by L.G. FEINSTEIN and R.J. PAGANO entitled "Ta Thin-Film Capacitors with an Al Underlay for High-Frequency Application", published in "IEEE TRANSACTIONS ON COMPONENT HYBRIDS, AND MANUFACTURING TECHNOLOGY", vol. CHMT-4, No. 1, March 1981. In the best of cases, with these methods the upper limit of the operating frequencies does not exceed 10 MHz, which is still a too low value for microwave applications.

The shortcoming of capacitors with anodized tantalum dielectric was known even before disclosure of the above mentioned articles, as appears in patent application US 4038167, P.L. Young, inventor, with priority 9 February 1976, in which is explained a method of manufacturing a thin-film capacitor on a dielectric substrate comprising in sequence the steps of:
- application of a first non-tantalum conductive film on the above mentioned dielectric substrate to form a first electrode of the capacitor;
- positioning of said substrate and the associated conductive film in a vacuum environment in which is introduced a gaseous mixture of oxygen and nitrogen;
- sputtering from tantalum pentoxide (Ta₂O₅) targets and deposit of an associated film of the desired thickness over said conductive film;
- cooling of said dielectric substrate and conductive film during deposit of the tantalum pentoxide, and subsequently
- application of a second non-tantalum conductive film to form a counter-electrode of the capacitor.

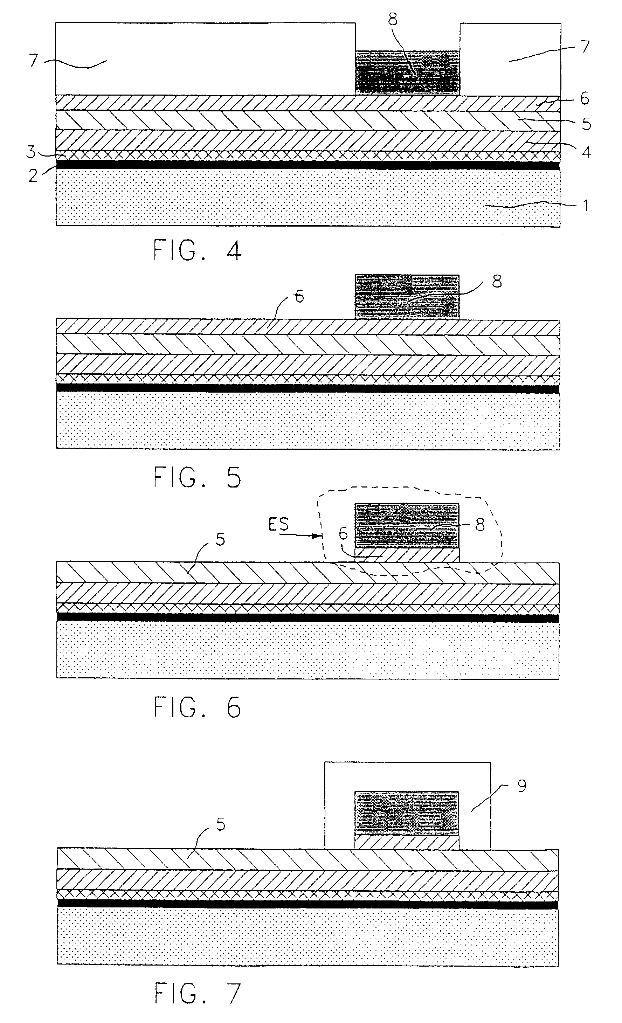

In the text and claims it is also stated that the conductive films making up the electrodes are of aluminum. It is necessary to specify that the method is addressed to the manufacture by sputtering of a capacitor with Ta₂O₅ dielectric, understood exclusively as a single component, and indeed nothing is said about how to integrate the method explained in a broader process for the manufacture of thin-film circuits comprising the capacitors, resistors and conductive lines. It must also be underlined that in the capacitors created by the above mentioned method there can easily occur short circuits between the electrodes, aided by the excessive nearness of the edges thereof, as may be seen in FIG 4, which shows a half-section of the capacitor consisting of the dielectric substrate with the three superimposed layers forming the capacitor, all of the same longitudinal dimension.

With respect to the capacitors created by the method of P.L. Young in which the Ta₂O₅ dielectric was created directly from Ta₂O₅ targets, the Ta₂O₅ dielectrics of the capacitors, integrated in thin-film circuits manufactured in conformity with the most recent manufacturing processes, are preferably created by performing a reactive sputtering from tantalum only in the presence of argon gas and oxygen. The problem of short circuits between the electrodes was solved by merely reducing the dimensions of the upper electrode with respect to the dielectric.

An example which illustrates the reactive Ta₂O₅ sputtering to create the dielectric of an integrated capacitor having greater surface area than that of the upper electrode is supplied in the article by A. Chu et al. entitled "A Two-Stage Monolithic IF Amplifier Utilizing a Ta₂O₅ Capacitor", published in "IEEE TRANSACTIONS ON ELECTRONIC DEVICES", VOL. ED-30, No 1, January, 1983. In FIG 4 of the article is given a sequence of steps of a manufacturing process of a monolithic integrated circuit (MMIC) operating at microwaves and where there is given greater emphasis to the production of a capacitor integrated in thin film placed between two GaAsFETs. In the first two steps of the process the GaAsFETs are almost completed, while the subsequent steps concern predominantly the production of the capacitor and related connections. In step 3 are deposited in sequence five layers, namely: Au, Ta, Ta₂O₅, Ta and Au in a single vacuum cycle and exclusively in the area occupied by the capacitor. In step 4 are partially etched the layers of Au and Ta deposited last, to create the upper electrode of the capacitor. In step 5 the Ta₂O₅ is partially etched on one side of the structure, uncovering in this manner a strip of the underlying metallization belonging to the lower electrode of the capacitor. The purpose is to create a zone for the subsequent anchoring of metallic connection lines. In step 6 is deposited photosensitive polyimide which, after masking, exposure and development, acts as support material in the production of a metallic air bridge, connecting the upper electrode of the capacitor to a GaAsFET. In step 7 is deposited by sputtering a metallization which covers the gate zone of the GaAsFETs, the residual polyimide, the uncovered metallic strip belonging to the lower electrode and a contiguous substrate zone starting close to the capacitor dielectric. In step 8 the electrolytic gold is grown on the preceding metallization but limited to the air bridge and along the paths corresponding to transmission lines or to those for connection to the capacitor. In step 9 the polyimide is removed and the sputtering metallization of step 7 is etched outside the electrolytic gold grown in step 8.

On page 22 of the article at the bottom of the first column it is stated that, concerning the layers deposited in step 3, the two tantalum layers serve to bond the Ta₂O₅ layer of the dielectric to the gold substrates of the electrodes, because without them adhesion of the Ta₂O₅ to the gold would be poor. It is also stated that, to minimize losses, the thickness of the tantalum layers should be held to the minimum required for good adhesion. The solution proposed is general in nature in thin-film technology and consists of using an interface layer between two others which, if placed in direct mutual contact, would show problems of compatibility concerning some physical characteristics such as e.g. adhesion, or solid diffusivity or other. In the case analyzed, the adhesion is presumably promoted by the formation of a Ta-Au alloy on one side of the interface and a Ta oxide with physical characteristics close to the Ta₂O₅ on the other side, where there can be seen a certain similarity with the anodized tantalum capacitors, which did not show any adhesion problem but had ohmic losses.

In thin-film circuit manufacturing processes allowing integration of the capacitors with the rest of the layout, it may be advantageous to use the steps of the process of A. Chu described above, but inheriting their shortcomings, among which there is that of having to deposit two additional tantalum layers with only interface functions and consequently that of not being able to fully utilize the good electrical conductivity of the gold of the electrodes, and thereby optimize the utilization band of the circuits as mentioned above. It is also pointed out that in the article in question nothing is said of the long-term mechanical stability of the capacitor structure, which is indeed quite complex.

Accordingly the purpose of the present invention is to overcome the above mentioned shortcomings and indicate a manufacturing process for thin-film circuits on dielectric substrates by means of which it would be possible to create capacitors having great capacitance density, great production simplicity, excellent mechanical and structural stability, and a very low dissipation factor making them suitable for microwave operation.

To achieve these purposes the present invention has for its subject matter a method according to claim 1. This manufacturing process for thin-film circuits on a dielectric substrate has the following phases:
- sequential cathode sputtering in a single vacuum cycle of metals which are deposited on the substrate to form superimposed layers and that is, in order, resistive, conductive, dielectric and conductive;
- definition of the geometry of upper electrodes of the capacitors and their creation by removal of material from the same conductive layer;
- definition of the geometry of dielectrics of the capacitors in surface zones more extensive than those of the corresponding upper electrodes and their creation by removal of material from the same dielectric layer;
- definition of the geometry of lower electrodes of the capacitors in surface zones more extensive than that of the corresponding dielectrics and electrodeposition of metal along conductive and resistive paths and close to the edge of the dielectrics in zones lying between the edges of the dielectrics and the corresponding lower electrodes;
- etching of the metallizations outside the metal deposited electrolytically, to create the capacitors and conductive lines connected to the lower electrodes;
- etching of the metallizations of the conductive lines in correspondence of the resistive paths, excepting the metal belonging to the first resistive layer to create the resistors; and
- execution of metallic air bridges to interconnect the upper electrodes of the capacitors to the rest of the circuit as better described in the claims.

The metals used in the base layers may be, in order, Ta, Ti, Pd, Ta and Pd, of which the tantalum of the first layer is doped with nitrogen, or nitrogen and oxygen, to aid deposit of a resistive layer. The titanium acts as an adhesive between the doped Ta and the first Pd layer. The second deposit of Ta takes place in the presence of oxygen to create a dielectric layer of Ta₂O₅. The layering which is created in the end is TaN, Ti, Pd, Ta₂O₅ and Pd, of which the layer of tantalum nitride TaN belongs to the resistors and the layers of Pd, Ta₂O₅ and Pd belong to the capacitors. The fact that the dielectrics extend beyond the edge of the corresponding upper electrodes allows good insulation between the opposing electrodes.

As may be seen, with respect to the method of A. Chu, the two interface layers between the Ta₂O₅ and the palladium electrodes of the capacitors are no longer necessary because the mechanical stability of the structure of the capacitors is perfectly assured by the thick gold crowns corresponding to the metallizations grown galvanically in contact with the lower electrodes and close to the dielectrics, and further by optional special provisions used in the sputtering phase of the layering of the base film as discussed below.

The structural strengthening is essentially due to the fact that the above mentioned crowns are firmly anchored to the underlying metallizations, thanks to the electrolytic growth and also shut up and lock the dielectrics while forming therewith hermetic joints. The existence of similar crowns is not the result of the above mentioned process nor of any of which we have knowledge. In the process of A. Chu, as appears from the figures, it can be seen that the metallization connecting the lower electrode to the rest of the circuit does indeed grow close to the dielectric but does not form a crown surrounding it and is absent in the zone underlying the air bridge connecting the upper electrode to the remaining circuit.

From tests performed in the applicant's laboratories on capacitors which differed from those created by the subject method only in that the gold crown metallization did not close around the dielectric, structural flaking off was observed with detachment of the Ta₂O₅ from the palladium of the lower electrode starting from the zone in which the crown did not close. This shows need of the crown, which strengthens the structure of the capacitors, and improves the electrical conduction to the lower electrodes, because it reduces their equivalent series resistance, thanks to a more efficient charge injection at the interface with the dielectric and to a more uniform distribution of current density on the surface of the lower electrodes. For the sake of brevity the proof of these assumptions, which were observed experimentally in the applicant's laboratory, is left out.

Further remarks regarding the total equivalent series resistance values created by the method in accordance with the present invention using the above-mentioned materials better justify the low values obtainable. Among these remarks are, 1) the palladium of the electrodes already has low resistivity per se, 2) the deposit of interface layers is not provided between the dielectric and the electrodes, 3) the low resistance of the thin layer of palladium belonging to the upper electrode is further reduced by the presence of a thick overlying gold layer, 4) the thickness of the palladium layer of the lower electrode is double that of the upper electrode, and 5) there is present a thick gold crown anchored to the lower electrode.

The advantages of the subject process are thus amply justified in the provision of integrated capacitors for microwave applications and to these is added the advantage of a greater simplification with respect to the known methods and due overall to the fact that the resistors and capacitors are created by subtraction starting from layers deposited by sputtering in an initial phase without breaking the vacuum cycle. A method of forming a resistor by subtraction is disclosed in EP-A-0 670 668. The specific advantage of the use of a single vacuum cycle is to be able to operate in a low-contamination environment and this implies greater integrity of the dielectrics of the finished capacitors and ultimately better production yield.

Further purposes and advantages of the present invention are clarified in the detailed description of an embodiment thereof given below by way of explanatory nonlimiting example and whose principal production phases are explained sequentially in FIGS 2 to 23 of the annexed drawings wherein for ease of representation the dimensions of the elements shown do not correspond to the real dimensions.

FIG 1 is a top view of a portion of the thin-film circuit as it appears at the end of the manufacturing process explained in the remaining FIGS In the FIG can be seen a substrate 1 supporting a resistor RES, a capacitor CAP and a connecting air bridge ABR placed between the two and partially superimposed on both.

The resistor RES consists of a resistive path 1r which breaks a conductive path 1c1 of which are also part the two terminals of RES, one of which is connected to one end of ABR and the other is broken on the left side of the FIG.

The capacitor CAP consists of an upper electrode ES superimposed on a dielectric DL which is in turn surrounded by a metallization COR as a crown completely superimposed on an equivalent portion of lower electrode which extends beyond the edge of the dielectric DL and consequently the lower electrode is hidden in the FIG. The crown COR belongs to a conductive path 1c2 which is broken on the right-hand side of the FIG. The upper electrode ES is in a central position with respect to the dielectric DL and has a smaller surface area than it, which is in turn surrounded by the crown COR. Therefore the bridge ABR bridges the dielectric DL and the crown COR and connects with the electrode ES to complete the series connection between CAP and RES. As set forth in the explanation of the following FIGS the conductive paths 1c1 and 1c2, the crown COR and the terminals of RES belong to a single conductive layout.

FIG 1 also shows an axis A-A which represents the trace of a plane of cut perpendicular to the substrate 1 along the center line of RES, ABR and CAP. The following FIGS from 2 to 23 refer without distinction to either of the two cross sections specular with respect to the axis A-A. The reference to the layout of FIG 1 in the above mentioned FIGS does not limit the process described through them and this allows creating the complete resistive, capacitive and conductive layout.

In FIG 2 can be seen no less than 5 superimposed layers indicated in order by 2, 3, 4, 5 and 6 and consisting predominantly of metallic material deposited on one side of the substrate 1 (termed hereinafter 'front'). Deposit of all the layers is performed by means of cathode vacuum metal 'sputtering', without breaking the vacuum cycle as better explained below. Since for the success of the process it was observed experimentally that the surface of the substrate 1 must be perfectly smooth, the choice of the material fell in a non-limiting manner on Corning glass 7059. It is however possible to use other known insulating materials such as e.g. alumina, sapphire, etc. In this case the substrates must be lapped or leveled if necessary by means of appropriate known processing.

The layer 2 adhering to the substrate 1 consists of resistive metal, e.g. tantalum or its compounds with nitrogen or nitrogen and oxygen. Tantalum nitride TaN is indicated below in a nonlimiting manner. The layer 3 consists of a good conducting metal with adhesive characteristics such as e.g. titanium. The layers 4 and 6 consist of the same good conducting metal having antidiffusive behaviour, e.g. palladium. The layer 5 consists of dielectric material, e.g. tantalum pentoxide Ta₂O₅.

The thickness of the layers 2, 3, 4, 5 and 6 of the nonlimiting example, that is TaN, Ti, Pd, Ta₂O₅ and Pd is respectively 0.1, 0.05, 0.5, 0,4, 0.25 µm. As may be seen, the layer 4 of Pd has a thickness double that of the Pd of layer 6. This provision serves to reduce the resistance value of the layer 4 from which will be made the lower electrode of the capacitor CAP (FIG 1) since this electrode is not in contact with the thick gold crown COR (FIG 1) in the zone underlying the dielectric.

For the sake of drawing convenience, in FIG 2 there is not shown on the back side of the substrate 1 an extended metallization acting as a ground plane. This metallization is performed in a separate vacuum cycle before deposit of the layers visible on the front side. The above mentioned metallization consists of a 0.05 µm layer of titanium deposited by sputtering directly in contact with the substrate 1. There follows a 0.25 µm layer of palladium grown in contact with the previous one in the same vacuum cycle. In an appropriate phase of the process, which is explained below, there is grown galvanically a gold layer in contact with the palladium layer to complete the ground plane. It is now also possible to integrate the process of the example with one of those known which allow creating ground deposits through metallized holes. For this purpose it is expedient to use the 'Process for the production of metallized holes in dielectric substrates comprising conductive and/or resistive paths in thin film interconnected with each other' described in European patent application EP-A-0 670 688 filed in the name of the same applicant. The most expedient point at which to activate the above mentioned process is indicated below.

The layering of FIG 2 allows only the subtractive creation of resistors and capacitors. This being the case, layer 2 taken alone constitutes the material of the resistive path which characterizes the resistor RES of FIG 1. Taken together with layers 3 and 4 it contributes to provision of the conductive paths. It is clear that to provide layers 2, 3, 4, 5 and 6 there can be used all those materials having similar electrical and physical characteristics whose use is known in thin-film technology.

Layers 4, 5 and 6 are part of the structure of the capacitor CAP and specifically the layers of Pd 4 and 6 belong respectively to the lower and upper electrodes of CAP and the layer 5 of Ta₂O₅ created as shown below belongs to the dielectric thereof.

At this point it is appropriate to clarify what was said in the introduction about the use in the subject process of particular provisions aiding adhesion between the Ta₂O₅ layer and the Pd layer. For this purpose it is useful to first describe briefly the deposition equipment, for which, for the sake of brevity, no figure is presented. As known, this equipment consists of a chamber in which are located the substrates to be metallized and placed on an appropriate plate and one or more metal disks, termed below 'targets', which will supply the material to create the layering of FIG 2. The interior of the chamber is kept under very hard vacuum by a high-vacuum pump having high pumping speed. It is however possible to introduce small gaseous flows having adjustable flowrate. The chamber is also equipped with all those sensors and actuators indispensable for accurate control of the deposit process. The plate and targets are connected to the terminals of a direct-current generator having rather high bias so that the whole assembly takes on a configuration similar to that of a diode with the cathode connected to the target and the anode connected to the substrate-holding plate. In series with the direct-current generator there can also be located a radiofrequency current generator with adjustable power. In the chamber is introduced an argon flow which is immediately ionized by the electrical field. The argon ions accelerated by the field violently strike the target connected to the cathode, removing the surface atoms, which are deposited on the substrates to metallize them. The movement of the ions in the chamber is equivalent to a current circulating between the generator electrodes. To aid metallization there can be applied to the substrate-holding plate a rotating movement with adjustable speed. The presence of several targets allows deposit of several superimposed metallic layers without having to open the chamber each time to change the target and break the vacuum. The presence of an electric heater allows changing the temperature of the substrates.

Even while keeping plasma production triggered, it is possible to prevent the metallic atoms of the target from reaching the substrates by inserting between the target and the substrate-holding plate a lamination termed hereinafter 'shutter'. This condition, termed hereinafter 'presputtering', has the purpose of taking the sputtering process to rated operation.

By using the same equipment it is also possible to perform surface treatments on substrates already metallized, an operation termed hereinafter 'etching'. A procedure designed for this purpose consists of closing the shutter to create the plasma merely by turning on the radiofrequency generator. Under these conditions the argon ions accelerated by the electrical field with radiofrequency strike the substrates and modify the surface morphology of the metallization.

The metal deposit or surface treatment operations described above involve mechanisms of an essentially physical nature. It is however possible to conjugate these mechanisms with those typical of chemical reactions to secure different advantages, among which the most important is that of being able to deposit compounds in addition to the metallic atoms, for example, the resistive compound of TaN or the dielectric compound of Ta₂O₅. The above mentioned procedure, termed hereinafter 'reactive sputtering', is clarified below for the process steps in which it is applied.

Now returning to the remarks made above on the existence of particular provisions introduced in the basic film sputtering phase, it is noted that their purpose is to aid adhesion between the Ta₂O₅ and the two Pd layers between which it is inserted. Therefore they are applied starting from the completed deposit of the lower layer 4 of Pd and comprise in succession the phases of:
- heating of the substrate 1 to approximately 100° C for 7 minutes;
- presputtering for approximately 8 minutes of the Ta target secured by closing the shutter to prevent metallization of the substrate 1 and introducing into the chamber a mixture of argon and oxygen and starting plasma production; the purpose is to appropriately condition the Ta target by taking it as near as possible to the condition it will achieve during the deposit phase so that the characteristics of the film deposited thereafter will be uniform from the start;
- surface treatment of the layer 4 of Pd and consisting of a limited etching in plasma of argon ions lasting only 2 minutes and supported by a radiofrequency power of approximately 30 mW/cm² with the purpose being to "roughen" the Pd surface and thus aid anchoring of the Ta₂O₅ layer which will subsequently be grown; and
- additional presputtering of the Ta target similar to the previous one but lasting approximately 4 minutes.

There then follows the actual sputtering of the Ta₂O₅ of the layer 5 performed by merely opening the shutter because working conditions remain identical to those of the preceding presputtering phase. Accordingly the sputtering of the Ta₂O₅ is the reactive type and is performed by introducing oxygen in the chamber during the tantalum sputtering.

By adopting appropriate values of the variables characterizing this sputtering phase, the whole of which is termed 'point of work', it was possible to secure the deposit of an amorphous film whose composition is near stoichiometric (O/Ta =2.5). Such a film possesses excellent dielectric characteristics while the capacitor resulting therefrom possesses low loss currents and high break-down voltages. The work point is defined in a non-limiting manner by the following values:
- S_{N2} = 485 I/s (pumping speed of the high-vacuum pump for nitrogen under standard conditions of 25 °C e 1.01 x 10⁵ Pa),
- Q_{Ar} = 60 sccm (flow of Ar expressed in cubic centimeters per minute under standard conditions);
- Q_{O2} = 46 sccm (flow of oxygen under standard conditions);
- pₜₒₜ = 0.41 Pa (total pressure in chamber);
- I = 3.7 A (electric current supported by the plasma);
- h = 100 mm (distance between targets and substrates); and
- V_{ω} = 1.05 rad/s (angular velocity of the substrate-holding plate).

With the provisions preceding the sputtering of the Ta₂O₅ of layer 5 the adhesion between the layer 4 of Pd and the layer 5 of Ta₂O₅ proved good.

Concerning the adhesion between the Ta₂O₅ layer 5 and the Pd layer 6 the only provision adopted was to precede the deposit of the layer 6 of Pd by a plasma treatment of the surface of the layer 5 of Ta₂O₅ consisting of a limited argon etching lasting only 2 minutes while using a radiofrequency power of approximately 30 mW/cm² as done previously for the Pd layer 4.

After creating the layering of FIG 2 the substrates are washed with a chromic mixture, rinsed and then dehydrated at 150° C for 15 minutes.

With reference to FIG 3 the conductive layer 6 is first covered uniformly with an emulsion 7 photosensitive to ultraviolet rays (termed hereinafter 'photoresist') over which is applied a mask (not shown in the figures) which is opaque to the radiation in a zone outside the surface of the upper electrode ES (FIG 1) of the capacitor CAP. This corresponds to the use of a positive photoresist 7, i.e. which depolymerizes in the part exposed to radiation. The photoresist 7 is exposed to the ultraviolet light through the mask and then developed chemically to eliminate the depolymerized part during development. If metallization of the ground plane is present on the back side of the substrate 1, it also must be protected by photoresist 7 to avoid the growth of gold during the next phase.

With reference to FIG 4, in the zone of the palladium layer 6 free of photoresist 7 there is grown galvanically a thickness of gold 8 of 2 to 3 µm.

With reference to FIG 5 the residual photoresist is removed chemically everywhere and the substrates are then washed in a chromic mixture and carefully rinsed.

With reference to FIG 6 the Pd layer 6 is removed outside the gold 8 by means of chemical etching in a solution based on FeCl₃ and 40% HF which does not corrode the Ta₂O₅ 5 of the gold 8. The etching time of the Pd 6 is short (approximately 2 minutes) to limit the effect of under-etching on the edge of the gold 8 and resulting reduction of the capacitance of the capacitor. The substrates are then washed in a chromic mixture, carefully rinsed and dehydrated at 150° C for 15 minutes to create the upper electrode ES of the capacitor.

With reference to FIG 7 the layer 5 of Ta₂O₅ is covered with photoresist 9, exposed with mask and developed to create the covering of the surface delimiting the dielectric DL (FIG 1).

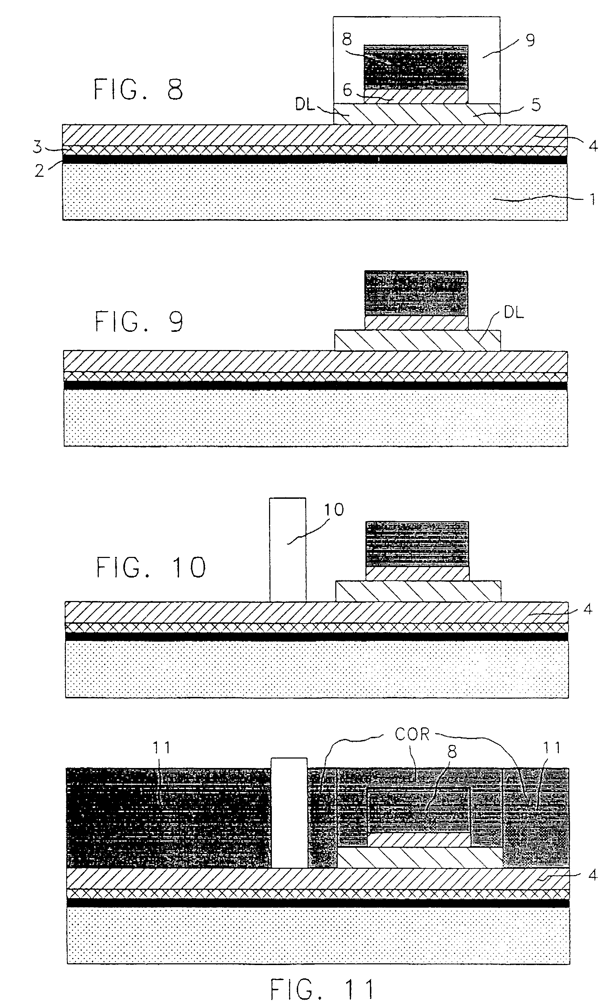

With reference to FIG 8 the layer 5 of Ta₂O₅ is removed outside the zone of the dielectric DL by using for the purpose equipment similar to that described for the sputtering of the layers 2, 3, 4, 5 and 6, but in this case the targets are missing and in addition the substrate-holding plates are directly connected to a terminal of an appropriate radiofrequency current generator. Recalling what was said about the reactive sputtering, even in case of plasma etching it is possible to give the process a chemical in addition to physical nature by using to produce the plasma an appropriate gas forming volatile compounds with the material to be removed (reactive ion etching - RIE). The etching of the layer 5 of Ta₂O₅ is performed in plasma of freon 14 (CF₄), with the use of this gas not being limiting in itself. During the bombardment more kinetic energy is conferred on the ions than that of the preceding surface treatments performed during the metallization operations of the substrate 1. The presence of a privileged direction of the incident ions confers on the plasma etching an anisotropic nature as opposed to the isotropy of a possible chemical etching in a liquid solution which allows limiting underengraving effects.

With reference to FIG 9 the residual photoresist 9 is removed to create the dielectric DL. There follows a phase of washing, rinsing and dehydration similar to the preceding ones.

With reference to FIGS 10 and 1 the layer 4 of Pd is covered with photoresist 10, exposed with a mask and developed to create zones free of photoresist 10 opposite the conductive paths 1c1 and 1c2, the resistive path 1r, and the lower electrode outside the dielectric DL.

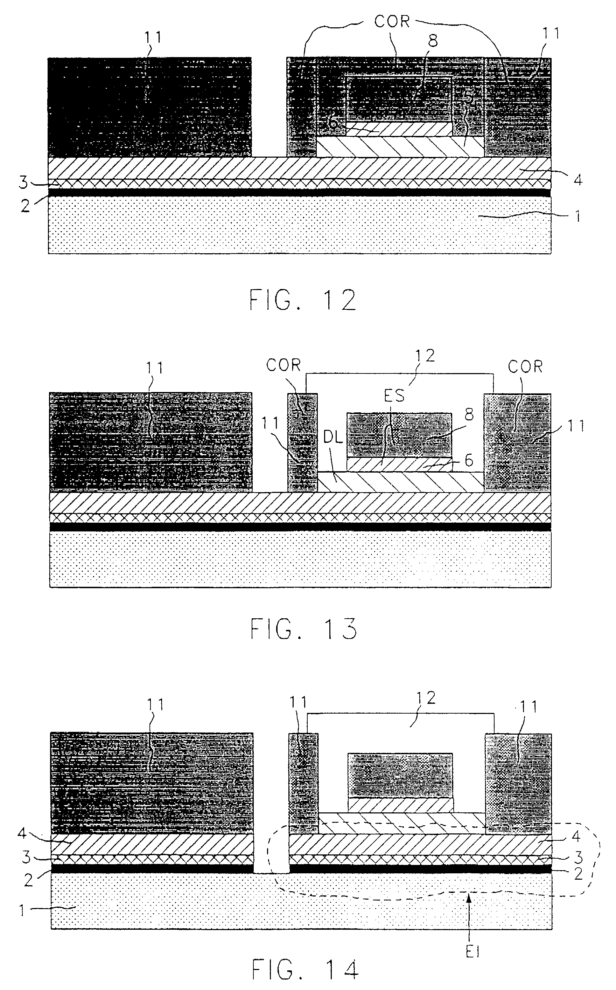

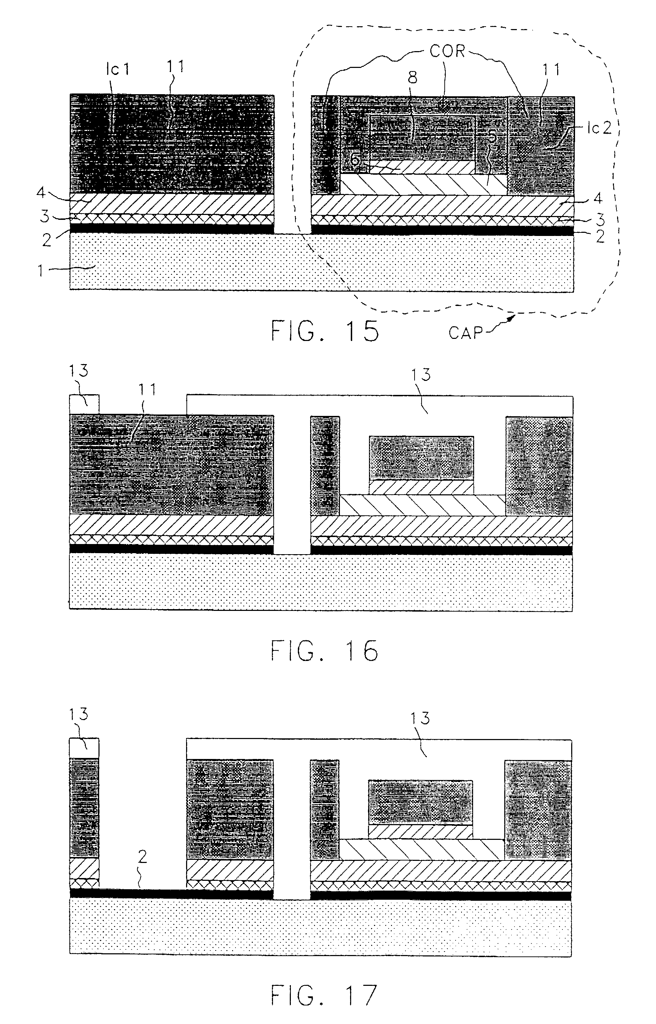

With reference to FIGS 11 and 1 there is grown galvanically a thickness of gold 11 of approximately 5 µm on the zones of the layer 4 of Pd free of the photoresist 10. The gold grows uniformly on the Pd 4 to form the conductive paths 1c1 and 1c2 and the crown COR and covering the resistive path 1r. On the upper electrode there is no further growth of gold in this phase, since the Ta₂O₅ 5 isolates the overlying gold 8 from the electrodes of the galvanic bath. In this phase the gold 11 grows galvanically even on the back side of the substrate 1 in contact with the existing palladium layer to improve the electric conductivity of the ground plane previously consisting of only the of titanium and palladium layers.

With reference to FIG 12, the residual photoresist 10 is removed everywhere and if necessary from the back also, and the substrate is carefully washed and rinsed.

The following FIGS 13, 14 and 15 concern removal of the layers 2, 3 and 4 of TaN, Ti and Pd respectively outside the electrolytic gold 11 to bare the surface of the substrate 1 to completely separate the conductive path 1c1 from the capacitor CAP. The removal can be performed chemically by using acid solutions which do not corrode the gold and the Ta₂O₅, or dry with the aid of plasmas having also selective chemical action (RIE). As regards the chemical etching, it would theoretically be possible to avoid protection of the capacitor CAP because the crown COR encloses the dielectric DL to form therewith a hermetically sealed joint for the acid solution, which thus cannot penetrate and corrode the metallizations 2, 3 and 4 of the lower electrode El.

With reference to FIG 13 it was considered expedient to protect with a thickness of photoresist 12 the upper electrode ES and the dielectric DL of the capacitor, to prevent the acid solution from engraving the Pd 6 along the edge underlying the gold 8 to alter the capacitive value of the capacitor. The protection supplied by the photoresist 12 proves suitable even when there is used a plasma reactive etching instead of the chemical one. In this case it would avoid possible partial removal of the Ta₂O₅ belonging to the uncovered crown of the dielectric DL extending beyond the edge of the upper electrode ES. On the other hand it is observed that the protection provided by the photoresist 12 would not be necessary if there were available acid solutions without underetching effect or if there were no need for high precision in the capacitance value of the capacitor.

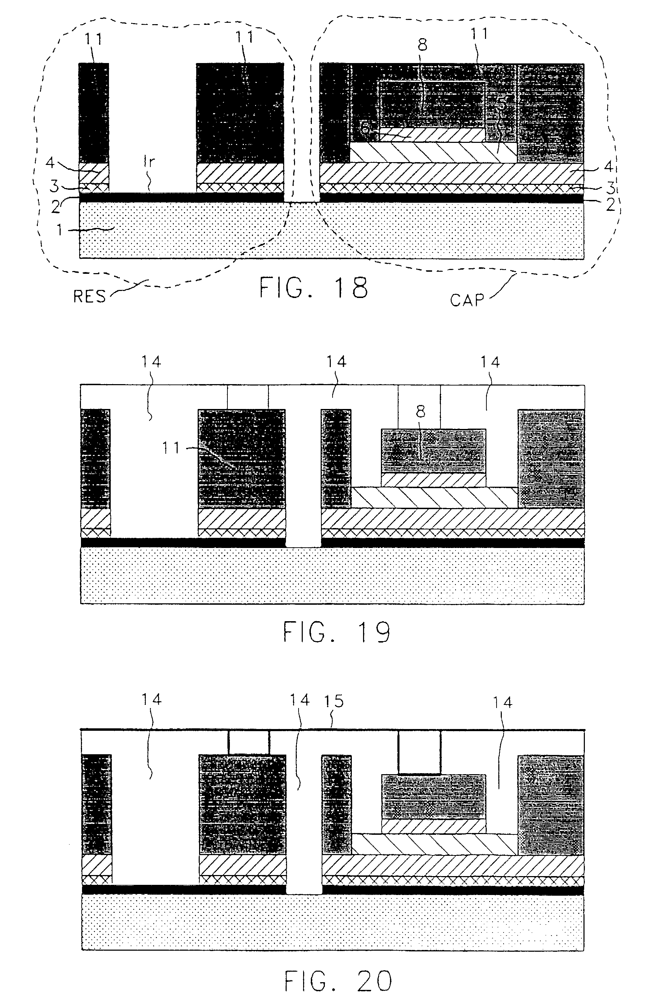

FIG 14 shows how the substrate 1 appears at the end of the chemical etching of the metallizations of the layers 2, 3 and 4 in the unprotected zones and FIG 15 shows the same substrate as in FIG 14 after removal of the residual photoresist 12.

As may be seen in FIG 15, the metallization of the crown COR keeps the capacitor CAP completely included in the conductive path 1c2 to form therewith a very compact structure which, while subjected to very severe environmental conditions characterized e.g. by the presence of mechanical vibrations or broad temperature ranges, never showed any mechanical failure or degradation in electrical operation.

The following FIGS 16, 17 and 18 refer to the creation of the resistor RES.

With reference to FIG 16 the substrate is covered with a layer of photoresist 13, exposed with a mask and developed to create a zone free of photoresist opposite the resistive path 1r of FIG 18. If on the back of the substrate 1 there is present the gold ground plane it also must be protected with photoresist 13 to avoid removal thereof during the next phase.

With reference to FIG 17 the layers of gold 11, palladium 4 and titanium 3 remaining uncovered by the photoresist 13 are removed with selective acid solutions which leave unchanged only the resistive layer 2 of TaN. After removal of all the residual layer of photoresist 13 there is created the circuit of FIG 18 in which is seen the resistor RES separated from the capacitor CAP. The circuit is however still not finished because there remains to be completed the connection of the upper electrode of CAP with the adjacent terminal of RES by means of the air bridge ABR of FIG 1.

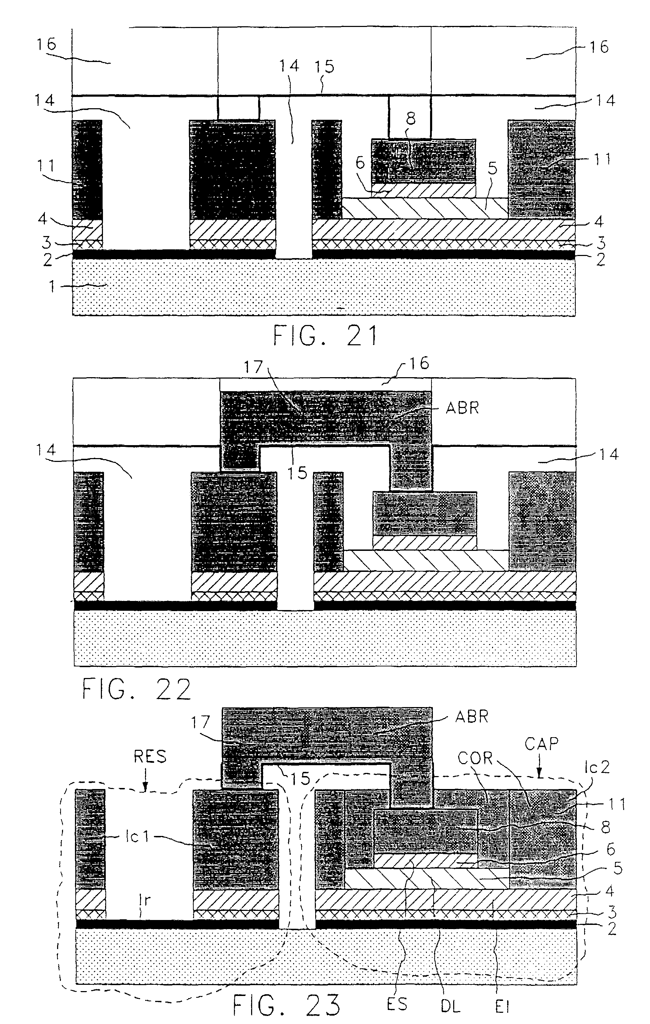

Before growth of the metallic bridge ABR and if the circuit requires it it is possible to provide holes in the dielectric substrate 1 which allow the connections to the ground plane using the process for metallization thereof as mentioned above. In the remaining FIGS 19, 20, 21, 22 and 23 there is illustrated the provision of the metallic bridge ABR (FIG 23).

With reference to FIG 19 the substrate 1 is covered with a layer of photosensitive polyimide 14 having the purpose of providing the frame of the bridge ABR (FIG 23). The polyimide 14 is exposed with a mask and developed to act as a photoresist by making openings where it is wished to make the piers of the bridge and in contact with the gold 11 of the resistor terminal and the gold 8 belonging to the upper electrode of the capacitor respectively.

With reference to FIG 20, on the entire surface of the residual polyimide there is deposited a thin conductive metallization for service 15 consisting of TiN and Au in such a manner as to allow electrolytic growth of gold in the subsequent phases.

With reference to FIG 21, on the entire surface of the metallization 15 there is deposited a layer of photoresist 16 which is exposed with a mask and developed to create a zone free of photoresist 16 which will be occupied by the bridge ABR (FIG 23). If on the back of the substrate 1 there is the metallization of the ground plane this also must be protected with photoresist 16 to avoid further growth of gold during the following phase.

With reference to FIG 22 a thickness of gold 17 is grown electrolytically in contact with the metallization 15 which is not covered by the residual photoresist 16. The gold 17 grows until completion of the bridge ABR.

With reference to FIG 23 the polyimide 14 and the photoresist 16 are removed everywhere to create the complete circuit consisting of the series connection of the resistor RES with the capacitor CAP which is implemented through the air bridge ABR.

With reference to the above FIGS there is now explained a small variant which avoids the initial growth of the gold 8 (FIG 4) opposite the upper electrode of the capacitor while combining this growth with that of the air bridge ABR (FIG 23). For this purpose and with reference to the process phase illustrated in FIG 3 it is necessary to protect with the photoresist 7 the Pd surface of the layer 6 corresponding to that of the upper electrode ES (FIG 1). This is a zone which is complementary to the protected one illustrated in FIG 3. After this, avoiding the phases illustrated in FIGS 4 and 5, all the remaining phases of the process illustrate in FIGS 6 to 18 remain unchanged. It is clear that the gold layer 8 will not appear in the above mentioned FIGS The phases which concern the fabrication of the bridge ABR and illustrated in FIGS 19 to 23 must be modified in such a manner as to cause the dimensions of the pier on the capacitor to coincide with those of the upper electrode ES unless there are tolerances in the centering of the masks.

## Claims

1. Manufacturing process for thin film circuits comprising at least one structure having a capacitor (CAP ; El, ES, DL, Ic2, COR) connected by an air bridge (ABR) to a resistor structure (RES) having a resistive path (Ir) and conductive terminals (Ic1) forming conductive lines on a planar dielectric substrate comprising in succession the steps of:
a) vacuum cathode sputtering of metals which are deposited on said substrate (1) to form a succession of superimposed layers of which a first layer (2) has resistive electrical characteristics, a second layer (3) is a good conductor with adhesive properties and a third layer (4) is a good conductor with antidiffusive properties, reactive vacuum cathode sputtering a fourth layer (5) having dielectric characteristics thereon, and vacuum cathode sputtering a metal thereon to deposit a fifth layer (6) having the same characteristics as the third;
b) covering of the metallized substrate (1) with a layer of a photosensitive lacquer (7) termed hereinafter 'photoresist', masking of zones corresponding to the positions of upper electrodes (ES) of capacitors (CAP), exposure and development to create zones of said fifth metallic layer (6) free of photoresist in the previously masked zones;
c) electrodeposition of metal (8), removal of the residual photoresist (7) and removal of said fifth metallic layer (6) outside said metal (8) grown by electrodeposition to create said upper electrodes (ES);
d) covering with photoresist (9) of the resulting structure, masking of zones which include said upper electrodes (ES) and the immediately neighbouring regions, exposure and development to create zones of said dielectric layer (5) free of photoresist outside the previously masked zones;
e) removal of said dielectric zones free of photoresist and removal of the residual photoresist (9) to create dielectrics (DL) of said capacitors (CAP) extending beyond the edge of said upper electrodes (ES);
f) covering with photoresist (10) of the resulting structure, masking of zones corresponding to lower electrodes (El) of said capacitors (CAP) with said zones including the surfaces of said dielectrics (DL) and the immediately neighbouring regions and masking of zones corresponding to where conductive lines that include said resistor structure (RES) are to be formed, exposure and development to create zones of said third metallic layer (4) free of photoresist (10) in the previously masked zones;
g) growth of metal (11) by electrodeposition on said zones of said third metallic layer (4) free of photoresist (10), with said metal (11) growing right up to the edges of said dielectrics (DL) to form crowns (COR, Ic2) hermetically enclosing the dielectrics (DL) and mechanically stabilizing the structure of the capacitors (CAP) and facilitating the conduction of current to the lower electrodes (El); and
h) removal of the residual photoresist (10) and removal of residual layers (2,3,4) from the zone previously covered by the residual photoresist (10), thus delineating the lower capacitor electrode (El) and the conductive lines that include the resistive paths (Ir);
i) covering with photoresist (13) of the resulting structure, masking of zones corresponding to where said resistive paths (Ir) are to be formed and which are not to be covered by said conductive metal (11), exposure and development to create zones free of photoresist in the previously masked zones;
I) removal of material (11,4,3) at those areas free of photoresist excepting the metal belonging to said first resistive layer (2) and removal of the residual photoresist (13) to create the resistor structures (RES); and
m) electrodeposition of metal (17) providing metallic air bridges (ABR) connecting said upper electrodes (ES) to said conductive terminals (Ic1) of said resistor structures (RES).

2. Manufacturing process in accordance with claim 1 and characterized in that:
- said first layer (2) with resistive electrical characteristics is tantalum or tantalum doped with nitrogen or with nitrogen and oxygen;
- said second layer (3) which is a good conductor with adhesive properties is titanium;
- said third layer (4) which is a good conductor with antidiffusive properties is palladium;
- said fourth layer (5) with dielectric characteristics is tantalum pentoxide (Ta₂O₅); and
- said fifth layer (6) is palladium.

3. Manufacturing process in accordance with claim 1 and characterized in that said metal (8,11,17) grown by electrodeposition in said step c), g) and m) is gold.

4. Manufacturing process in accordance with claim 1 and characterized in that said third layer (4) has a thickness double that of said fifth layer (6).

5. Manufacturing process in accordance with claim 1 or 2 and characterized in that said step a) of vacuum cathode sputtering of metals on said substrate (1) is completed without breaking the vacuum cycle and in that the deposition of said fourth dielectric layer (5) is preceded by appropriate substeps introduced to aid adhesion between said third (4) and fourth (5) layers whose sequence is as follows:
a1) heating of said substrate (1) to approximately 100° C for 7 minutes;
a2) conditioning of a metal target used in depositing said fourth dielectric layer (5) so as to bring the surface of said target to a condition as near as possible that reached during said reactive sputtering of the fourth layer (5);
a3) surface treatment of said third layer (4) to roughen its surface and aid anchoring of said fourth dielectric layer (5) subsequently deposited; and
a4) additional conditioning of said metal target similarly to that of said substep a2) but lasting half as long.

6. Manufacturing process in accordance with claim 1 or 2 and characterized in that the vacuum cathode sputtering of metals in the said step a) is completed without breaking the vacuum cycle, and in that the deposition of said fifth layer (6) is preceded by a substep a5) in which a surface treatment of said fourth dielectric layer (5) is carried out designed to aid adhesion between said fourth (5) and fifth (6) layers.

7. Manufacturing process in accordance with claim 5 characterized in that the vacuum cathode sputtering of metals in the said step a) is completed without breaking the vacuum cycle and in that the deposition of said fourth dielectric layer (5) takes place by introducing oxygen in the vacuum chamber during a cathode sputtering of tantalum with the following values of the principal physical variables which control the process during deposit of said dielectric layer (5):
- S_{N2} = 485 I/s where S_{N2} is the pumping speed of a high-vacuum pump used to produce the vacuum in said chamber and where I/s refers to nitrogen under standard conditions of 25° C and 1,01.10⁵ Pa;
- Q_{Ar} = 60 sccm, where Q_{Ar} is a flow of Ar and sccm is a measure of said flow in cubic centimeters per minute under standard conditions;
- Q_{O2} = 46 sccm, where Q_{O2} is a flow of oxygen;
- Pₜₒₜ = 0,41 Pa, where pₜₒₜ is the total pressure in said chamber;
- I = 3.7 A where I is an electrical current supported by the plasma present in said chamber;
- h = 100 mm where h is a distance between said cathode sputtered tantalum and said substrate (1); and
- V_{ω} = 1.05 rad/s, where V_{ω} is the angular velocity of a plate bearing said substrate (1).

8. Manufacturing process in accordance with claim 5 and characterized in that said conditioning implemented in said substep a2) is a cathode sputtering of the metal of said target in the presence of argon and oxygen lasting approximately 8 minutes and in which the deposition of metal on said substrate (1) is prevented.

9. Manufacturing process in accordance with claim 5 and characterized in that said surface treatment implemented in said substep a3) is a bombardment in plasma of argon ions lasting approximately 2 minutes and supported by a radiofrequency power of approximately 30 mW/cm².

10. Manufacturing process in accordance with claim 6 and characterized in that said surface treatment implemented in said substep a5) is a bombardment in plasma of argon ions lasting approximately 2 minutes and supported by a radiofrequency power of approximately 30 mW/cm².

11. Manufacturing process in accordance with claim 1 and characterized in that said removal steps e), h) and I) include a selective chemical etching.

12. Manufacturing process in accordance with claim 1 and characterized in that at the end of said step g), said step h) is preceded by a step g') in which said substrate (1) is covered with photoresist (12), zones superimposed on said upper electrodes (ES), on said dielectrics (DL) and partially on said metallic crowns (COR) are masked, said photoresist (12) is exposed through the masks and developed to create zones free of photoresist outside the previously masked zones with the residual photoresist after development protecting said upper electrode (ES) during said removal of residual metallic layers (2,3,4) performed during said step h) and being removed at the end thereof.

13. Manufacturing process in accordance with claim 1 or 12 and characterized in that:
- in said step b) the zones of said fifth metallic layer (6) free of photoresist (7) are created outside the previous masked zones;
- in said step c) said fifth metallic layer (6) is removed outside the previous masked zones and there is then removed the residual photoresist (7) to create said upper electrodes (ES); and
- in said step m) said metal (17) grown by electrodeposition and providing said metallic air bridges (ABR) covers the entire surface of said upper electrodes (ES).

14. Manufacturing process in accordance with any one of the above claims and characterized in that said step a) is preceded by the deposit of an extensive metallization acting as a ground plane on the face of said substrate (1) opposite that including said thin film circuits.

15. Manufacturing process in accordance with claim 14 and characterized in that said step m) is preceded by the provision of metallized holes for the connections to said ground plane.

16. Manufacturing process in accordance with any one of the above claims and characterized in that said substrate (1) is made of glass or a ceramic material appropriately leveled or of any dielectric material having a plane surface.

## Patentansprüche

1. Verfahren zur Herstellung von Dünnfilmschaltungen, die mindestens eine Struktur mit einem Kondensator (CAP, El, ES, DL, Ic2, COR) einschließen, der durch eine Luftbrücke (ARB) mit einer Widerstandsstruktur (RES) mit einem Widerstandsverlauf (Ir) und Leiteranschlußstellen (Ic1), die leitfähige Leitungen auf einem ebenen dielektrischen Substrat bilden, wobei das Verfahren folgende Schritte unfaßt:
a) Vakuumkathodenzerstäubung von Metallen, die auf dem genannten Substrat (1) abgelagert werden, um eine Reihe von übereinanderliegenden Schichten zu bilden, von denen die erste Schicht (2) elektrische Widerstandseigenschaften aufweist, eine zweite Schicht (3) ist ein guter Leiter mit Hafteigenschaften und die dritte Schicht (4) ist ein guter Leiter mit Anti-Diffusionsmerkmalen, eine reaktive Vakuumkathode spritzt eine 4. Schicht (5) mit dielektrischen Merkmalen auf, und eine Vakuumkathode die ein Metall auf, um darauf eine fünfte Schicht (6) aufzutragen, die die gleichen Eigenschaften wie die dritte hat;
b) Abdeckung des metallisierten Substrats (1) mit einer Schicht mit photochromatischen Lack, der nachfolgend "Phororesist" genannt wird, der die Bereiche maskiert, die den Positionen von oberhalb liegende Elektroden (ES) von Kondensatoren (CAP) entsprechen, Belichtung und Entwicklung, um von Photoresist freie Bereiche der genannten fünften Schicht (6) in den zuvor maskierten Zonen zu schaffen;
c) galvanische Auftragen einer Metallschicht (8), Entfernung des verbleibenden Photoresists (7) und Entfernung der genannten fünften, durch galvanisches Aufbringen entstandenen Metallschicht (6) zur Verwirklichung der genannten oberen Elektroden;
d) Abdeckung mit Photoresist (9) der resultierenden Struktur, Maskierung der Bereiche, die die genannten oberen Elektroden (ES) und die unmittelbar anliegenden Zonen einschließen, Belichtung und Entwicklung, um Zonen der genannten dielektrischen Schicht (5), die außerhalb der vorher maskierten Bereiche frei ist von Photoresist;
e) Entfernung der genannten dielektrischen, von Photoresist freien Bereiche und Entfernung des verbleibenden Photoresists (9), um Nichtleiter (DL) der genannten Kondensatoren (CAP) zu schaffen, die über den Rand der genannten oberen Elektroden (ES) hinausgehen;
f) Abdeckung mit Photoresist (10) der resultierenden Struktur, Maskierung von Bereichen, die unteren Elektroden (El) der genannten Kondensatoren mit den genannten Zonen entsprechen, die die Oberflächen der genannten Nichtleiter (DL) und die unmittelbar anliegenden Bereiche einschließen, und Maskierung von Zonen, wo leitende, die genannte Widerstandsstruktur einschließende Leitungen gebildet werden müssen, Belichtung und Entwicklung, um Bereichre der genannten dritten Metallschicht (4) zu schaffen, die in den vorher masklierten Zonen frei sind von Photoresist;
g) Metallpotenzierung (11) durch galvanisches Auftragen in den genannten Bereichen der genannten dritten, von Phororesist (10) freien Metallschicht (4), wobei das genannte Metall (11) direkt bis zu den Rändern der genanten Nichtleiter (DL) verstärkt wird, um Kronen (COR, Ic2) zu bilden, die die Nichtleiter (DL) hermetisch und mechanisch enschließen;
h) Entfernung des verbleibenden Photoresists (10) und Entfernung der verbleibenden Schichten (2, 3, 4) in den zuvor durch den verbleibenden Photoresist (10) abgedeckten Zonen, wodurch die untere Kondensatorenelektrode (El) und die leitenden, die Widerstandsverläufe (Ir) einschließenden Leitungen skizziert werden;
i) Abdeckung mit Photoresist (13) der resultierenden Struktur, Maskierung der entsprechenden Bereiche, in denen die genannten Widerstandsverläufe (Ir) zu bilden sind und die nicht durch das genannte leitende Metall (11) abzudecken sind, Belichtung und Entwicklung um Zonen zu schaffen, die in den zuvor maskierten Bereichen frei sind von Photoresist;
l) Entfernung von Material (11, 4, 3) in den von Photoresist freien Bereichen, mit Ausnahme des zur genannten ersten Widerstandsschicht (2) gehörenden Metalls und Entfernung des verbleibenden Photoresists (13) um die Widerstandsstruktur (RES) zu schaffen, und
m) galvanisches Auftragen von Metall (17), wobei metallische Luftbrücken (ABR) vorgesehen werden, die die genannten oberen Elektroden (ES) mit den genanten leitenden Anschlusstellen (Ic1) der genannten Widerstandsstruktur (RES) verbinden.

2. Herstellungsverfahren entsprechend Anspruch 1, dadurch gekennzeichnet, daß:
- die genannte erste Schicht (2) mit ohmschen elektrischemn Merkmalen besteht aus Tantal oder mit Stickstoff oder mit Stickstoff und Sauerstoff gedopten Tantal;
- die genannte zweite Schicht (3), die einen guten Leiter mit Hafteigenschaften darstellt, besteht aus Titan;
- die genannte dritte Schicht (4), die einen guten Leiter mit Anti-Diffusionseigenschaften darstellt, besteht aus Palladium;
- die genannte vierte Schicht (5) mit dielektrischen Eigenschaften besteht aus Tantalpentoxid (Ta₂O₅); und
- die genannte fünfte Schicht (6) besteht aus Palladium.

3. Herstellungsverfahren entsprechend Anspruch 1 und dadurch gekennzeichnet, daß das in den Schritten c) g) und m) galvanisches aufgebrachte Metall (8, 11, 17) Gold ist;

4. Herstellungsverfahren entsprechend Anspruch 1 und dadurch gekennzeichnet, daß die genannte dritte Schicht (4) die doppelt so stark ist wie die fünfte Schicht (6);

5. Herstellungsverfahren entsprechen Anspruch 1 oder 2, dadurch gekennzeichnet, daß der genannte Schritt a) der Vakuumkathodenzerstäubung von Metallen auf dem genannten Substrat (1) abgeschlossen wird, ohne den Vakuumzyklus zu unterbrechen, und daß dem Aufbringen der genannten vierten dielektrischen Schicht (5) geeignete Zwischenschritten, die eingeschoben werden, um das Haften zwischen der genannten dritten (4) und vierten (5) zu unterstützen, wobei diese Zwischenschritte die folgende Reihenfolge aufweisen:
a1) Erhitzen des genannten Substrats (1) auf etwa 100° für 7 Minuten;
a2) Behandlung eines Metalltargets, das für das Aufbringen der genannten vierten dielektrischen Schicht (5) benutzt wird, um so die Oberfläche des genannten Targets in einen Zustand zu versetzen, der so nah wie möglich an den herankommt, der während der rückwirkenden Kathodenzerstäubung der vierten Schicht (5) erzielt wird;
a3) Oberflächenbehandlung der genannten dritten Schicht (4) um ihre Oberfläche anzurauhen und die Verankerung der genannten nachfolgend aufgetragenen vierten dielektrischen Schicht (5) zu unterstützen;
a4) zusätzliche Behandlung des genannten Metalltargets ähnlich der des Zwischenschritts a2), jedoch mit einer halb so langen Dauer.

6. Herstellungsverfahren entsprechend Anspruch 1 oder 2, dadurch gekennzeichnet, daß die Vakuumkathodenzerstäubung von Metallen im genannten Schritt a) abgeschlossen wird, ohne den Vakuumzyklus zu unterbrechen, und dadurch daß dem Aufbringen der genannten fünften Schicht (6) ein Zwischenschritt a5) vorausgeht, in dem eine Oberflächenbehandlung der genannten vierten dielektrischen Schicht durchgeführt wird, die geeignet ist, das Haften zwischen der genannten vierten (5) und fünften (6) Schicht zu fördern.

7. Herstellungsverfahren entsprechend Anspruch 5, dadurch gekennzeichnet, daß die Vakuumkathodenzerstäubung von Metallen im genannten Schritt a) abgeschlossen wird, indem Sauerstoff in die Vakuumkammer während einer Kathodenzerstäubung von Tantal eingeführt wird, und zwar mit den folgenden Werten der wesentlichen physischen Variablen, die den Prozess während des Aufbringens der genannten dielektrischen Schicht (5) steuern:
- S_{N2} = 485 I/s, wobei S_{N2} die Pumpgeschwindigkeit einer Hochvakuumpumpe ist, die benutzt wird, das Vakuum in der genannten Kammer herzustellen, und wobei I/s sich auf Stickstoff unter Standardbedingungen von 25° C und 1.01,10⁵ Pa bezieht;
- Q_{Ar} = 60 sccm, wobei Q_{Ar} ein Fluß von Ar ist umnd sccm ist ein Maß des genannten Flusses in Kubikzentimetern pro Minute under Standartvorausetzungen;
- Q_{O2} = 46 sccm, wobei Q_{O2} ein Sauerstoffstrom ist;
- Pₜₒₜ = 0,41 Pa, wobei Pₜₒₜ der Gesamtdruck in der genannten Kammer ist;
- I = 3,7 A, wobei I ein elektrischer Strom ist, der durch das in der Kammer vorhandene Plasma untersttützt wird;
- H = 100 mm, wobei h die Entfernung zwischen dem kathodenversprühten Tantal und dem genannten Substrat (1) ist; und
- V_{(I)} = 1,05 rad/s, wobei V_{(I)} die Winkelgeschwindigkeit einer Platte ist, die das genannte Substrat (1) trägt.

8. Herstellungsverfahren entsprechend Anspruch 5, dadurch gekennzeichnet, daß es sich bei der in Teilschritt a2) genannte Behandlung um eine Kathodenzerstäubung des Metalls des genannten Targets in Gegenwart von Argon und Sauerstoff handelt, wobei die genannte Behandlung ungefähr 8 Minuten dauert und während der das Auftragen von Metall auf dem genannten Substrat (1) verhindert wirde.

9. Herstellungsverfahren entsprechend Anspruch 5, dadurch gekennzeichnet, daß es sich bei der genannte, im Zwischenschritt a3 ausgeführte Oberfächenbehandlung um einen Beschuß in Plasma von Argon-Ionen von einer etwa dreiminütigen Dauer handelt, der von einer Radiofrequenzstärke von circa 30 mW/cm² unterstützt wird.

10. Herstellungsverfahren entsprechend Anspruch 6, dadurch gekennzeichnet, daß res sich bei der im Zwischenschritt a5) ausgeführten, ungefähr zwei Minuten dauernden Oberflächenbehandlung um einen Beschuß in Plasma von Argon-Ionen, der von einer Radiofrequenzstärke von circa 30 mW/cm² unterstützt wird.

11. Herstellungsverfahren entsprechend Anspruch 1, dadurch gekennzeichnet, daß die genannten Abtragungsschritte e), h) und l) ein selektives, chemisches Ätzen einschließt.

12. Herstellungsverfahren entsprechend Anspruch 1, dadurch gekennzeichnet, daß am Ende des Schrittes g), dem genannte Schritt h) ein Schritt g') vorausgeht, in dem das genannte Substrat (1) mit Photoresist (12) abgedeckt wird und Bereiche maskiert werden, die über den genannten oberen Elektroden (ES), den genannten Nichtleitern (DL) und teilweise über den genannten Metallkronen (COR) liegen, wobei der genannte Photoresist (12) durch die Masken belichtet und entwickelt, um außerhalb der zuvor maskierten Bereiche zu schaffen, wobei der nach der Entwicklung verbleibende Photoresist die genannten oberen Elektroden (ES) während des Schrittes h) dauernden Abtragens der verbliebenen Metallschichten (2, 3 und 4) schützt und am Ende dieses Schritts entfernt wird.

13. Herstellungsverfahren entsprechend Anspruch 1 oder 12, dadurch gekennzeichnet, daß
- während des genannten Schritts b) die Bereiche der genannten, von Photoresist (7) freien fünften Metallschicht (6) außerhalb der vorher maskierten Bereiche geschaffen werden;
- während des genannten Schrittes c) die genannte fünfte Metallschicht (6) außerhalb der zuvor maskierten Bereiche entfernt und dann dort der verbleibende Photoresist (7) entfernt wird, um die genannten oberen Elektroden (ES) zu schaffen; und
- während des genannten Schrittes m) das genannte, durch Elektrodenauftragung aufgebrachte Metall, durch das die genannte Luftbrücke geschaffen wird, die gesamte Oberfläche der genannten oberen Elektroden (ES) abdeckt.

14. Herstellungsverfahren entsprechend irgendeinem der vorstehenden Ansprüche, dadurch gekennzeichnet, daß Schritt a) dem Auftragen ein extensives Metallisieren vorausgeht, das als Grundplan auf der Außenfläche des genannten Substrats fungiert, die der gegenüberliegt, die die genannten Dünnfilmschaltungen einschließt.

15. Herstellungsverfahren entsprechend Anspruch 14, dadurch gekennzeichnet, daß dem genannten Schritt m) die Schaffung metallisierter Löcher zwecks Verbindung mit dem genannten Grundplan vorausgeht.

16. Herstellungsverfahren entsprechen irgendeinem der vorstehenden Ansprüche, dadurch gekennzeichnet, daß das genannte Substrat (1) aus auf geeignete Weise abgeflachtem Glas oder Keramikmaterial oder irgendeinem nichtleitenden Material mit planer Oberfläche besteht.

## Revendications

1. Procédé pour fabriquer des circuits a film mince, qui comprennent au moins une structure avec un condensateur (CAP, El, ES, DL, Ic2, COR) connecté à une structure de résistance (RES) avec un parcours résistif (Ir) et des bornes conductibles (Ic1), qui constituent des lignes conductibles sur un substrat diélectrique planar, et tel procédé comprend successivement les phases de:
a) pulvérisation cathodique sous vide de métaux, qui se déposent sur le dit substrat (1) pour former une série de couches superposées, desquelles une première couche (2) avec des caractéristiques électriques résistives, une deuxième couche (3) est un bon conducteur avec des propriétés adhésives et une troisième couche (4) est un bon conducteur avec des propriétés antidiffusives, une pulvérisation cathodique réactive sous vide d'une quatrième couche (5) avec des caractéristiques diélectriques, et la pulvérisation cathodique sous vide d'un métal d'une cinquième couche (6) avec les mêmes caractéristique de la troisième;
b) couverture du substrat métallisé (1) avec une couche de laque photosensible (7) dénommée par la suite "photoresist", qui masque des zones, qui correspondent aux positions d'électrodes supérieures (ES) de condensateurs (CAP), exposition et développement pour créer des zones de la dite cinquième couche métallique (6) privée de photoresist dans les zones précédemment masquées;
c) accroissement de métal (8) de manière galvanique, enlèvement de la dite cinquième couche métallique (6) en dehors de la dite couche métallique (8) accrues de manière galvanique pour créer les dites électrodes supérieures (ES);
d) couverture de photoresist (9) de la structure obtenue masquant les zones, qui comprennent les dites électrodes supérieures (ES) et les régions immédiatement voisinantes, exposition et développement pour créer des zones de la dite couche diélectrique (5) libres de photoresist en dehors des zones masquées précédemment;
e) enlèvement des dites zones diélectriques privées de photoresist et enlèvement du photoresist (9) résidu pour créer des diélectriques (DL) des dits condensateurs (CAP), qui s'étendent excédant le bord des dites électrodes supéerieures (ES);
f) couverture de photoresist (10) de la structure obtenue, masquage de zones correspondantes aux électrodes inférieures (El) des dits condensateurs (CAP) avec, où les dites zones comprennent les surfaces des dites diélectriques (DL) et les régions immédiatement voisinants, et masquage de zones correspondantes aux endroits où des lignes conductibes, qui comprennent la dite structure de résistance (RES), doivent être crées, exposition et développement pour créer des zones de la dite troisième couche métallique (4) privée de photoresist (10) dans les zones précédemment masquées;
g) accroissement de métal (11) de manière galvanique sur les zones de la dite troisième couche métallique (4) privée de photoresit (10) avec le dît métal (11) accroissant jusqu'aux bords des dites diélectriques (DL) pour former des couronnes (COR, lc2) incluant de manière hermétique les diélectriques (DL) et stabilisant mécaniquement la structure des condensateurs (CAP) et facilitant la conduction de courant aux électrodes inférieures El), et
h) enlèvement du photoresist résidu (10) et enlèvement des couches restantes (2, 3, 4) des zones précédemment couvertes par le photoresist résidu (10), délinéant de cette manière l'électrode de condensateur inférieure (El) et les lignes conductibles, qui comprennent les parcours résistifs (Ir);
i) couverture avec photoresist (13) de la structure résultante, masquage de zones correspondantes aux endroits où les dits parcours résistifs (Ir) doivent être formés et qui ne doivent pas être couvertes par le dît métal conducteur (11), exposition et développement pour créer des zones privées de photoresist dans les zones précédemment masquées;
I) enlèvement de matériel (11, 4, 3) dans ces régions privées de photoresist à l'exception du métal appartenant à la dite première couche résistive (2) et enlèvement du photoresist restant (13) pour créer les structures de résistance (RES), et
m) accroissement de métal (17) de manière galvanique créant des ponts métalliques en air (ABR), qui connectent les dites électrodes supérieures (ES) aux dites bornes conductibles (Ic1) des dites structures de résistance (RES).

2. Procédé de fabrication selon la revendication 1, caractérisé en ce que:
- la dite première couche (2) avec des caractéristiques électrique résistives consiste en tantale ou tantale dopé de nitrogène ou de nitrogène et oxygène;
- la dite deuxième couche (3), qui est un bon conducteur avec des propriétés adhésives consiste en titane;
- la dite troisième couche (4), qui est un bon conducteur avec des propriétés antidiffusives consiste en palladium;
- la dite quatrième couche (5) avec des caractéristiques diélectriques consiste en tantale pentoxyde (Ta₂O₅); et
- la dite cinquième couche (6) consiste en palladium.

3. Procédé de fabrication selon la revendication 1, caractérisé en ce que le dît métal (8, 11, 17) accru de manière galvanique pendant les phases c), g) et m) consiste en or.

4. Procédé de fabrication selon la revendication 1, caractérisé en ce que la dite troisième couche (4) a une épaisseur double de celle de la dite cinquième couche (6).

5. Procédé de fabrication selon la revendication 1 ou 2, caractérisé en ce que la dite phase a) de pulvérisation cathodique de métaux sous vide sur le dît substrat (1) est complétée sans interrompre le cycle de vide et en ce que la déposition de la dite quatrième couche diélectrique (5) est précédée par des phases secondaires appropriées introduites pour favoriser l'adhésion entre les dites troisième (4) et quatrième (5) couches, dont la séquence est la suivante:
a1) réchauffement du dît substrat (1) à approximativement 100° C pour 7 minutes;
a2) traitement superficiel d'un dît target en métal utilisé pour la déposition de la dite quatrième couche diélectrique (5) et de manière de porter la surface à une condition plus proche possible à celle achevée pendant la dite pulvérisation réactive de la quatrième couche (5);
a3) traitement de surface de la dite troisième couche (4) pour en gratter la surface et favoriser l'ancrage de la dite quatrième couche diélectrique (5) déposée par la suite; et
a4) traitement supplémentaire du dît target en métal similaire à celui de la phase secondaire a2) mais seulement avec une durée réduite à moitié.

6. Procédé de fabrication selon la revendication 1 ou 2, caractérisé en ce que la pulvérisation cathodique sous vide de métaux dans la dite phase a) est achevée sans interrompre le cycle de vide, et en ce que la déposition de la dite cinquième couche (6) est précédée par une phase secondaire a), pendant laquelle un traitement de surface de la dite quatrième couche diélectrique (5) est effectué pour favoriser l'adhésion entre les dites quatrième (5) et cinquième (6) couches.

7. Procédé de fabrication selon la revendication 5, caractérisé en ce que la dite pulvérisation cathodique sous vide de métaux pendant la dite phase a) est complétée sans interruption du cycle de vide et en ce que la déposition de la dite quatrième couche diélectrique (5) a lieu introduisant de l'oxygène dans la chambre à vide pendant une pulvérisation cathodique de tantal avec les valeurs suivantes des principales variables physiques, qui contrôlent le procès pendant la déposition de la dite couche diélectrique (5):
- S_{N2} = 485 I/s où S_{N2} est la vitesse de pompage d'une pompe a vide poussé utilisée pour produire le vide dans la dite chambre, et où I/s réfère à nitrogène à des conditions standard de 25°C et 1,01.10⁵ Pa;
- Q_{Ar} = 60 sccm, où Q_{Ar} est un courant de Ar et sccm est une mésure du dît courant en centimètres cube par minute à des conditions standard;
- Q_{O2} = 46 scc, où Q_{O2} est un courant d'oxygène;
- pₜₒₜ = 0,41 Pa, où pₜₒₜ est la pression totale dans la dite chambre;
- I = 3,7 A, où I est un courant électrique supporté par le plasma présent dans la dite chambre;
- h = 100 mm, où h est une distance entre le dît tantale déposé par pulvérisation cathodique et le dît substrat (1); et
- Vₘ = 1,05 rad/s, où Vₘ est la vitesse angulaire d'un plat, qui porte le dît substrat (1).

8. Procédé de fabrication selon la revendication 5, caractérisé en ce que le dît traitement effectué pendant la phase secondaire a2) est une pulvérisation cathodique du métal du dît target en présence d'argon et oxygène, qui dure approximativement 8 minutes et pendant laquelle la déposition de métal sur le dît substrat (1) est empêchée.

9. Procédé de fabrication selon la revendication 5, caractérisé en ce que le dît traitement de surface effectué pendant la dite phase secondaire a3) est un bombardement en plasma d'ions d'argon, qui dure environ 2 minutes et supporté par une puissance à radiofréquence approximativement de 30 mW/cm².

10. Procédé de fabrication selon la revendication 6, caractérisé en ce que le dît traitement de surface effectué pendant la dite phase secondaire a5) est un bombardement en plasma d'ions d'argon, qui dure approximativement 2' et il est supporté par une puissance à radiofréquence approximativement de 30 mW/cm².

11. Procédé de fabrication selon la revendication 1, caractérisé en ce que les dites phases d'enlèvement e) h) et I) comprennent une gravure chimique sélective.

12. Procédé de fabrication selon la revendication 1, caractérisé en ce que à la fin de la phase g) la phase h est précédée d'une phase g'), pendant laquelle le dît substrat (1) est couvert de photoresist (12), les zones superposées sur les dites électrodes supérieures (ES), sur les dites diélectriques (DL) et partialement sur les dites couronnes métalliques (COR) sont masquées, le dît photoresist (12) est exposé à travers les masques et développé pour créer des zones privées de photoresist en dehors des zones précédemment masquées avec le photoresist restant après le développement protégeant les dites électrodes supérieures pendant le dît enlèvement de couches métalliques restantes (2, 3, 4) effectué pendant la dite phase h) et étant enlevé à la fin de celle-ci.

13. Procédé de fabrication selon la revendication 1 ou 12, caractérisé en ce que:
- pendant la dite phase b) les zones de la dite cinquième couche métallique (6) privée de photoresist (7) sont crées en dehors des zones précédemment masquées;
- pendant la dite phase c) la dite cinquième couche métallique (6) est enlevée en dehors des zones précédemment masquées, et puis le photoresist restant (7) est enlevé obtenant les dites électrodes supérieures (ES);
- pendant la dite phase m) le dît métal (17) accru de manière galvanique en correspondance des dits ponts métalliques en air (ABR) recouvre la surface complète des dites électrodes supérieures (ES).

14. Procédé de fabrication selon n'importe laquelle des revendications mentionnées ci-dessus, caractérisé en ce que la dite phase a) est précédée par la déposition d'une métallisation extensive avec la fonction de plan de masse sur la face du dît substrat (1) opposé à celle, qui comprend les dits circuits à film mince.

15. Procédé de fabrication selon la revendication 14, caractérisé en ce que la dite phase m) est précédée par la réalisation de trous métallisés pour la connexion avec le dît plan de masse.

16. Procédé de fabrication selon n'importe laquelle des revendication précédentes, caractérisé en ce que le dît substrat (1) est fait de verre ou de céramique nivelé de manière appropriée ou de n'importe quel matériel diélectrique avec une surface plane.
